(19) Europäisches Patentamt
European Patent Office
Office européen des brevets

(11) **EP 2 649 416 B1**

(12) **EUROPÄISCHE PATENTSCHRIFT**

(45) Veröffentlichungstag und Bekanntmachung des Hinweises auf die Patenterteilung:
**10.01.2018 Patentblatt 2018/02**

(21) Anmeldenummer: **11785584.1**

(22) Anmeldetag: **03.11.2011**

(51) Int Cl.:
*G01B 21/16* (2006.01)     *G05B 15/02* (2006.01)
*H03M 1/26* (2006.01)     *H04Q 9/00* (2006.01)
*G01D 21/00* (2006.01)

(86) Internationale Anmeldenummer:
**PCT/EP2011/005545**

(87) Internationale Veröffentlichungsnummer:
**WO 2012/076087 (14.06.2012 Gazette 2012/24)**

(54) **VERFAHREN UND VORRICHTUNG ZUR ZYKLISCHEN DIGITALEN ÜBERTRAGUNG EINES POSITIONSWERTES EINES BEWEGTEN OBJEKTES MIT TRÄGER MASSE**

METHOD AND DEVICE FOR THE CYCLIC DIGITAL TRANSMISSION OF A POSITION VALUE OF A MOVING OBJECT HAVING AN INERTIAL MASS

PROCÉDÉ ET DISPOSITIF POUR UNE TRANSMISSION NUMÉRIQUE CYCLIQUE D'UNE VALEUR DE POSITION D'UN OBJET SE DÉPLAÇANT, POURVU D'UNE MASSE D'INERTIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **10.12.2010   DE 102010054141
31.05.2011   DE 102011103735**

(43) Veröffentlichungstag der Anmeldung:
**16.10.2013   Patentblatt 2013/42**

(60) Teilanmeldung:
**15002899.1 / 2 998 710
15002900.7 / 3 001 152
15002901.5 / 2 998 711**

(73) Patentinhaber: **Sew-Eurodrive GmbH & Co. KG
76646 Bruchsal (DE)**

(72) Erfinder: **SIMON, Olaf
76646 Bruchsal (DE)**

(56) Entgegenhaltungen:
**DE-B3-102007 062 333**

EP 2 649 416 B1

**Beschreibung**

Die Erfindung betrifft ein Verfahren und Vorrichtung zur zyklischen digitalen Übertragung eines Positionswertes eines bewegten Objektes mit träger Masse.

Winkelsensoren sind allgemein bekannt. Bei Winkelsensoren, die als Inkrementalgeber ausgeführt sind, wird der erfasste Winkelwert einer Welle digital übertragen.

**Aus der** DE 10 2007 062 333 B3 **ist als nächstliegender Stand der Technik ein Verfahren und Vorrichtung zur zyklischen digitalen Übertragung eines Positionswertes eines bewegten Objektes mit träger Masse bekannt.**

Der Erfindung liegt daher die Aufgabe zugrunde, die Übertragung der erfassten Werte vom Winkelsensor an ein elektronisches Gerät weiterzubilden, wobei eine gegen Störungen robuste Datenübertragung verwendet werden soll.

Erfindungsgemäß wird die Aufgabe bei der Verfahren zur zyklischen digitalen Übertragung eines Positionswertes eines bewegten Objektes mit träger Masse nach den in Anspruch 1 und bei der Vorrichtung nach den in Anspruch 11 angegebenen Merkmalen gelöst.

Wichtige Merkmale der Erfindung bei dem Verfahren zur zyklischen digitalen Übertragung eines Positionswertes eines bewegten Objektes mit träger Masse sind, dass der Wertebereich des übertragenen Positionswertes derart eingeschränkt ist, dass sich keine vollständige Umdrehung oder im Fall einer linearen Bewegung andere durch mechanische Gegebenheiten bedingte vollständige Periode abbilden lässt und die tatsächliche Position durch Erkennen von Wertebereichsüberschreitungen in einer Auswerteeinheit gebildet wird,

- wobei zu einem ersten Zeitpunkt eine nicht oder eine weit weniger stark wertebereichsbeschränkte Position als im kontinuierlichen Betrieb übertragen wird

- und/oder wobei der Wertebereich dadurch bestimmt wird, dass die in einem Abtastzyklus auftretende Wegdifferenz bei maximaler Geschwindigkeit kleiner als die Hälfte des gewählten Wertebereichs ist, wobei der Wertebereich möglichst klein gewählt wird

und/oder wobei anstelle der wertebereichsbeschränkenden Absolutposition die Differenz zur vorherigen Position mit gleicher Wertebereichsbeschränkung übertragen wird.

Von Vorteil ist dabei, dass die digitale Übertragung robust ist gegen Störeinwirkungen, wie beispielsweise Magnetfeldeinstrahlungen oder dergleichen.

Wichtige Merkmale bei einem Verfahren zur zyklischen digitalen Übertragung eines Positionswertes eines bewegten Objektes mit träger Masse, sind, dass der Wertebereich des übertragenen Positionswertes derart eingeschränkt ist, dass sich keine vollständige Umdrehung oder im Fall einer linearen Bewegung andere durch mechanische Gegebenheiten bedingte vollständige Periode abbilden lässt und die tatsächliche Position durch Erkennen von Wertebereichsüberschreitungen in einer Auswerteeinheit gebildet wird, insbesondere

- wobei zu einem ersten Zeitpunkt eine nicht oder eine weit weniger stark wertebereichsbeschränkte Position als im kontinuierlichen Betrieb übertragen wird

- und/oder wobei der Wertebereich dadurch bestimmt wird, dass die in einem Abtastzyklus auftretende Wegdifferenz bei maximaler Geschwindigkeit kleiner als die Hälfte des gewählten Wertebereichs ist, wobei der Wertebereich möglichst klein gewählt wird

- und/oder wobei anstelle der wertebereichsbeschränkenden Absolutposition die Differenz zur vorherigen Position mit gleicher Wertebereichsbeschränkung übertragen wird.

Von Vorteil ist dabei, dass ein nur geringer Datenstrom übertragen werden muss und somit eine geringe Bandbreite ausreicht für die Übertragung. Außerdem ist eine erhöhte Sicherheit realisierbar, da nach Übertragen des vollständigen Positionswertes ein Vergleich mit dem aus dem wertebereichseingeschränkten Wert bestimmten Positionswert ausführbar ist und somit überwachbar ist, ob die maximal erlaubte Beschleunigung überschritten wurde, also ein unvorhergesehenes Ereignis, wie Fehler oder dergleichen, aufgetreten ist. Alternativ ist auch das zyklische Übertragen des vollständigen Positionswerts verzichtbar, wodurch somit eine Datenverbindung mit geringer Bandbreite ausreicht für eine schnelle Positionswertübertragung. Die von einem Sensor erfassten Daten sind also komprimierbar und datenkomprimiert übertragbar.

Durch den Vergleich der Differenz mit dem halben Wertebereich ist eine Rekonstruktion der vollständigen Information über den Positionswert in einfacher Weise ausführbar.

Wichtige Merkmale bei einem alternativen Verfahren zur zyklischen digitalen Übertragung eines Positionswertes eines bewegten Objektes mit träger Masse nach Anspruch 2 sind, dass der Wertebereich des übertragenen Positionswertes gegenüber dem Wertebereich möglicher Positionswerte eingeschränkt ist, insbesondere so dass sich keine vollständige Umdrehung oder im Fall einer linearen Bewegung andere durch mechanische Gegebenheiten bedingte vollständige Periode abbilden lässt, und die tatsächliche Position dadurch bestimmt wird, dass aus der vorherigen Position und der vorherig bestimmten Geschwindigkeit ein Schätzwert für die Position gebildet wird und diese mittels des wertebereichsbeschränkten übertragenen Positionswertes korrigiert wird, insbesondere

- wobei durch einen Vergleich des wertebereichsbeschränkten Positionsschätzwertes mit dem wertebereichsbeschränkten übertragenen Positionswert eine Wertebereichsüberschreitung ermittelt und zur Korrektur des Schätzwertes herangezogen wird,

- und/oder wobei einmalig am Anfang eine Position übertragen wird, deren Werteberiech den Bereich möglicher auftretender Positionen umfasst

- und/oder wobei anstatt der wertebereichsbeschränkten Absolutposition die Differenz zur vorherigen Position mit gleicher Wertebereichsbeschränkung übertragen wird.

Von Vorteil ist dabei, dass der Positionswert an einer trägen Masse erfasst wird. Durch die daher ermöglichte Begrenzung der auftretenden Beschleunigungen und Rucke, also zeitlichen Ableitungen der Beschleunigungen, ist ermöglicht, dass die Geschwindigkeitsänderung in der zugehörigen Zykluszeit begrenzt ist und somit ein Schätzwert nur korrigiert werden muss um weniger als eine Auflösungseinheit, beispielsweise einer grob aufgelösten Spur.

Wichtige Merkmale bei einem Verfahren zur digitalen Übertragung eines Positionswertes eines bewegten Objektes mit träger Masse nach Anspruch 3 sind, dass der Positionswert gekennzeichnet ist durch zumindest zwei Werte, insbesondere Teilwinkelwert und Subwinkelwert und/oder Feinwinkelwert, insbesondere digitale Werte,

wobei der erste Wert mit einer ganzen Zahl kennzeichenbar ist und jeder Zahl ein Positionswertebereich zugeordnet ist,

wobei jedem durch einen ersten Wert gekennzeichneten Positionsbereich zueinander separate Teilbereiche des Positionsbereichs zugeordnet sind, wobei jeder dieser Teilbereiche durch einen zweiten Wert gekennzeichnet ist, der als ganze Zahl kennzeichenbar ist,

wobei zu einem ersten Zeitpunkt ein Positionswert erfasst wird und der zugehörige erste und zweite Wert übertragen wird,

wobei

(i) ein weiterer Positionswert erfasst wird und der zugehörige, somit neu erfasste, zweite Wert übertragen wird,

(ii) worauf aus dem neu erfassten, zweiten Wert und dem zuvor erfassten, zweiten Wert der durch den ersten Wert gekennzeichnete Positionswertebereich bestimmt wird, also somit auch der zum neu erfassten Positionswert zugehörige erste Wert.

Von Vorteil ist dabei, dass wiederum zu einem ersten Zeitpunkt die vollständige Information über den erfassten Positionswert vorliegt und somit ein daraufhin nur relativ zu diesem ersten Positionswert bestimmter neuer Positionswert bestimmt wird. Somit ist eine komprimierte Datenübertragung ermöglicht oder eine erhöhte Redundanz bei der Datenübertragung.

Bei einer vorteilhaften Ausgestaltung weist der Positionswert einen Winkelwert eines drehenden Teiles, also Objektes, wobei das Objekt als träge Masse ein Trägheitsmoment auf. Von Vorteil ist dabei, dass die volle Umdrehung von 360° in mehrere Teilbereiche aufteilbar ist und somit eine Auflösung der vollen Umdrehung in die so entstandenen Positionswertebereiche ermöglicht ist.

Bei einer vorteilhaften Ausgestaltung wird die Übertragung zeitlich wiederkehrend wiederholt, insbesondere also zyklisch wiederholt wird, insbesondere in regelmäßigen Zeitabständen,

insbesondere wobei Schritt (i) und (ii) mehrfach nacheinander ausgeführt werden. Von Vorteil ist dabei, dass ständig wiederkehrend die Position bestimmbar ist. Dabei sind die Zeitabstände vorzugsweise derart kurz, dass wiederum die maximal zu erwartende Positionswertänderung unterhalb eines kritischen Wertes verbleibt, der vorzugsweise einen halben Positionswertebereich unterschreitet.

Bei einer vorteilhaften Ausgestaltung wird bei Schritt (ii) aus dem zuvor erfassten oder bestimmten Positionswert und der zugehörigen Geschwindigkeit ein Schätzwert bestimmt und der zweite Wert des neu erfassten Positionswertes mit dem zweiten Wert des Schätzwertes verglichen und die Differenz zwischen dem zweiten Wert des neu erfassten Positionswertes und dem zweiten Wert des Schätzwertes bestimmt und daraus der zum neu erfassten Positionswert zugehörige Positionsbereich bestimmt. Von Vorteil ist dabei, dass ein Geschwindigkeitswert bekannt ist und daher ein Schätzwert überhaupt bestimmbar ist, indem zum alten Positionswert die aus der Geschwindigkeit und dem zugehörigen Zeitintervall sich ergebende Positionswerteänderung addiert wird.

Bei einer vorteilhaften Ausgestaltung wird bei Schritt (ii) die Differenz zwischen neu erfasstem zweiten Wert und zuvor erfasstem zweiten Wert bestimmt, insbesondere wobei bei Überschreiten eines halben Positionsbereichs darauf geschlossen wird, dass der neu erfasste Positionswert in einem benachbarten Positionsbereich liegt. Von Vorteil ist dabei, dass in einfacher Weise aus der bloßen Differenz und dem Wissen über die maximal zu erwartende Änderung des Positionswertes der neue Positionswert vollständig bestimmbar ist, obwohl nur ein eingeschränkter Wertebereich übertragen werden muss.

Bei einer vorteilhaften Ausgestaltung wird bei Schritt (ii) ein Vergleich zwischen neu erfasstem zweiten Wert und zuvor erfasstem zweiten Wert bestimmt und derjenige benachbarte Bereich bestimmt, in welchem der neu erfasste Positionswert sich befindet, insbesondere wenn die Differenz zwischen neu erfasstem zweiten Wert und zuvor erfasstem zweiten Wert einen halben Positionsbereich überschreitet. Von Vorteil ist dabei, dass in einfacher Weise ein vollständiges Bestimmen des Positionswertes trotz der übertragenen und eingeschränkten Information ermöglicht ist.

Bei einer vorteilhaften Ausgestaltung ist die Änderung der Geschwindigkeit zwischen zwei in einem Zeitabstand Δt nacheinander ausgeführten Positionserfassungen auf einen kritischen Wert begrenzt, insbesondere welcher durch die träge Masse bestimmt oder zumindest mitbestimmt ist. Von Vorteil ist dabei, dass nur eine endliche Anzahl, insbesondere Zwei, von möglichen Positionswerten erreichbar ist und nur aus dieser endlichen Anzahl der neue Positionswert bestimmt werden muss.

Bei einer vorteilhaften Ausgestaltung ist der Positionswert ein Winkelwert oder eine Linearposition, insbesondere wobei die Geschwindigkeit eine Winkelgeschwindigkeit oder eine in Linearrichtung auftretende Geschwindigkeit ist. Von Vorteil ist dabei, dass die Erfindung bei rotatorischen und linearen Antriebsregelungen verwendbar ist, also unabhängig von der Sorte des Positionserfassenden Sensors.

Bei einer vorteilhaften Ausgestaltung sind ein erster und zweiter Wert einer jeweiligen Spur, insbesondere Geberspur, zugeordnet, wobei der erste Wert einer feiner auflösenden Spur als der zweite Wert zugeordnet ist. Von Vorteil ist dabei, dass nur ein eingeschränkter Informationswert übertragen werden muss und trotzdem die vollständige Information über die Position erhältlich ist.

Bei einer vorteilhaften Ausgestaltung sind jedem durch einen zweiten Wert, insbesondere Subwinkelwert, gekennzeichneten Positionsbereich zueinander separate Teilbereiche des Positionsbereichs zugeordnet, wobei jeder dieser Teilbereiche durch einen dritten Wert, insbesondere Feinwinkelwert, gekennzeichnet ist, der als ganze Zahl kennzeichenbar ist, insbesondere wobei zu dem ersten Zeitpunkt der Positionswert erfasst wird und der zugehörige erste und zweite und dritte Wert übertragen wird, wobei der dritte mit dem zweiten Wert übertragen wird, insbesondere vor oder nach dem zweiten Wert. Von Vorteil ist dabei, dass als erster Wert ein Teilwinkel und als zweiter Wert ein Subwinkel erfassbar und übertragbar sind, wobei der Subwinkel durch ein Feinwinkelbereich noch feiner auflösbar ist. Dabei genügt dann die Übertragung der Feinwinkel und Subwinkelinformation, um den grober auflösenden Teilwinkel zu bestimmen.

Wichtige Merkmale bei dem Verfahren zur Regelung eines Antriebs sind, dass zeitlich wiederkehrend ein Positionswert erfasst wird und die zugehörige Information an eine Regelvorrichtung übertragen wird, insbesondere mit einem Verfahren nach mindestens einem der vorangegangenen Ansprüche, wobei der Positionswert gekennzeichnet ist durch zumindest zwei Werte, insbesondere Teilwinkelwert und Feinwinkelwert, insbesondere digitale Werte, wobei der erste Wert mit einer ganzen Zahl kennzeichenbar ist und jeder Zahl ein Positionswertebereich zugeordnet ist,

wobei jedem durch einen ersten Wert gekennzeichneten Positionsbereich zueinander separate Teilbereiche des Positionsbereichs zugeordnet sind, wobei jeder dieser Teilbereiche durch einen zweiten Wert gekennzeichnet ist, der als ganze Zahl kennzeichenbar ist, wobei der zweite Wert zeitlich vor dem ersten Wert übertragen wird, wobei

(i) nach Übertragen des neu erfassten zweiten Wertes aus dem neu erfassten und dem zuvor übertragenen zweiten Wert ein erster Wert bestimmt wird, welcher dem neu erfassten ersten Wert entspricht, und der so bestimmte Positionswert von einer Regeleinrichtung verwendet wird, um einen aktualisierten Wert einer Stellgröße der Regeleinrichtung zu bestimmen,

insbesondere wobei der Schritt (i) wiederholt wird.

Von Vorteil ist dabei, dass die Zeitdauer der Übertragung des ersten Wertes schon nutzbar ist zur Bestimmung des nächsten Stellgrößenwertes.

Wichtige Merkmale bei dem Verfahren zur Regelung eines Antriebs sind, dass zeitlich wiederkehrend ein Positionswert erfasst wird und die zugehörige Information an eine Regelvorrichtung übertragen wird, wobei der Positionswert gekennzeichnet ist durch zumindest zwei Werte, insbesondere Teilwinkelwert und Feinwinkelwert, insbesondere digitale Werte, wobei der erste Wert mit einer ganzen Zahl kennzeichenbar ist und jeder Zahl ein Positionswertebereich zugeordnet ist,

wobei jedem durch einen ersten Wert gekennzeichneten Positionsbereich zueinander separate Teilbereiche des Positionsbereichs zugeordnet sind, wobei jeder dieser Teilbereiche durch einen zweiten Wert gekennzeichnet ist, der als ganze Zahl kennzeichenbar ist, wobei der zweite Wert zeitlich vor dem ersten Wert übertragen wird, wobei

(i) nach Übertragen des neu erfassten zweiten Wertes aus dem neu erfassten und dem zuvor übertragenen zweiten Wert unter zusätzlicher Berücksichtigung der zuletzt bestimmten Geschwindigkeit, ein erster Wert bestimmt wird, welcher dem neu erfassten ersten Wert entspricht, und der so bestimmte Positionswert von einer Regeleinrichtung verwendet wird, um einen aktualisierten Wert einer Stellgröße der Regeleinrichtung zu bestimmen,

(ii) wobei nach Übertragung des neu erfassten zweiten Wertes aus dem neu erfassten ersten Wert und neu erfassten zweiten Wert der Geschwindigkeitswert aktualisiert wird, wobei auch der zuvor erfasste erst Wert und der zuvor erfasste zweite Wert berücksichtigt wird,

wobei die Schritte (i) und (ii) wiederholt werden. Von Vorteil ist dabei, dass auch bei einer auftretenden Geschwindigkeit ein Schätzwert bestimmbar ist und dieser nur noch korrigiert werden muss.

Bei einer vorteilhaften Ausgestaltung wird nach Übertragen des ersten Wertes dieser verglichen mit dem gemäß Schritt (i) bestimmten Wert und bei Abweichung eine Aktion ausgelöst wird, insbesondere wie Anzeigen und/oder Übermitteln einer Warninformation und/oder Abschalten des Antriebs und/oder Auslösen eines Sicheren Zustandes des Antriebs. Von Vorteil ist dabei, dass die Sicherheit erhöht ist.

Bei einer vorteilhaften Ausgestaltung wird in einem Sensor ein Positionswert erfasst und der Sensor ist über eine digitale Schnittstelle mit einer Auswerteeinheit verbunden,

wobei die Auswerteeinheit einen Speicher aufweist und Mittel zur Bestimmung des Positionswertes aus einem übertragenen wertebereichsbeschränkten Positionswert aufweist,

insbesondere wobei die Auswerteeinheit mit einer Regeleinrichtung verbunden ist.

Von Vorteil ist dabei, dass nur eine geringe Bandbreite bei der Datenübertragung notwendig ist.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von schematischen Abbildungen näher erläutert:

Bei dem erfindungsgemäßen Antriebssystem ist ein Winkelsensor mit einer Welle des Antriebs, beispielsweise Motorwelle eines umrichtergespeisten Elektromotors oder mit einer Welle eines von einem umrichtergespeisten Elektromotor angetriebenen Getriebes, drehfest verbunden, so dass die Winkelstellung erfassbar ist.

Hierbei wird in einem ersten Zeitabschnitt der Winkelwert in digitaler Form, also als digitales Telegramm oder Wort, übertragen.

Der an die Signalelektronik des Umrichters übertragene Wert wird von einer in der Signalelektronik vorgesehenen Regeleinheit verwendet, um den Motorstrom durch Stellen der Motorspannung auf einen jeweiligen gewünschten Sollwert hin zu regeln.

Der Winkelwert wird dabei gekennzeichnet durch einen Teilwinkelbereich und zumindest noch einen Feinwinkelbereich. Dabei ist der Teilwinkel nur eine grobe Auflösung der gesamten Umdrehung von 360°. Der Feinwinkel unterteilt den jeweiligen Teilwinkelbereich in feinere Winkelabschnitte.

Bei der Übertragung des Winkelwertes wird zeitlich zuerst der Feinwinkelwert übertragen und danach der grobere Teilwinkelwert.

Durch Berücksichtigung von kritischen Werten, insbesondere maximalen Beschleunigungswerten und/oder maximalen Rucken, also zeitlichen Ableitungen der Beschleunigung, und unter Berücksichtigung des zuletzt bekannten Winkelwerts und Winkelgeschwindigkeitswerts ist es für die Signalelektronik ermöglicht, schon aus den Feinwinkelwerten den neu erfassten winkelwert zu bestimmen.

Auf diese Weise ist es der Regeleinheit ermöglicht, besonders früh den neu erfassten Winkelwert für die Regelung zu berücksichtigen. Zur erfindungsgemäßen Bestimmung des neu erfassten Winkelwertes sind nur wenige Rechenschritte notwendig, weshalb nur wenig Rechenzeit aufgewendet werden muss. In der Regeleinheit wird dann aus dem so bestimmten Winkelwert und weiteren Werten der jeweils neu vom Umrichter zu stellende Motorspannungswert berechnet.

Während dieser Berechnungszeit werden dann auch die gröberen Teilwinkelwerte vom Winkelsensor an die Signalelektronik des Umrichters übertragen.

Somit ist dann rechtzeitig vor dem nächsten Zeitschritt der wirkliche erfasste Winkelwert direkt bekannt. Somit ist dann die Sicherheit erhöht, da der aus dem Feinwinkel bestimmte und der in Gänze übertragene Winkelwert miteinander verglichen werden kann. Außerdem ist für die nächste Winkelbestimmung aus dem nächsten Feinwinkelwert unter Verwendung des ganz übertragenen Winkelwerts und eines entsprechend aktualisierten Winkeigeschwindigkeitswerts ausführbar.

Somit wird - mit anderen Worten - also in jedem Zeitschritt der zuletzt vollständig, umfassend also Feinwinkelwert und Teilwinkelwert, übertragene Wert verwendet und unter Differenzbildung zum vorherigen Wert die aktualisierte Geschwindigkeit bestimmt. Aus diesen Werten wird dann ein Schätzwert bestimmt für den nächsten zu erwartenden Winkelwert. Zur Bestimmung dieses Winkelwertes wird berücksichtigt, dass der Antrieb eine träge Masse, insbesondere linear oder rotatorisch, antreibt und dabei die Geschwindigkeit im zugehörigen Zeitschritt nur um einen maximalen Betrag sich ändern kann. Dieser so bestimmte Schätzwert ist auch durch einen Feinwinkelwert, einen Teilwinkelwert und gegebenenfalls einen Subwinkelwert kennzeichenbar. Der dann neu übertragene Feinwinkelwert des neu erfassten und vom Winkelsensor übertragenen Winkelwerts wird dann verwendet zur Bestimmung des neuen Winkelwerts, welcher dann sofort von der Regeleinheit verwendet wird. Nach der parallel hierzu erfolgten vollständigen Übertragung des neu erfassten Winkelwerts wird dann ein Vergleich ausgeführt mit dem nur aus dem übertragenen Feinwinkeiwert bestimmten Wert, wodurch eine Sicherheitsgerichtete Überprüfung ausführbar ist. Das Verfahren wird wiederholt, wobei aus dem vollständig übertragenen Winkelwert wiederum die aktualisierte Winkelgeschwindigkeit bestimmt wird und dann entsprechend wiederholend verwendet wird.

In einer Ausführungsvariante wird der vollständig übertragene Winkelwert nur zu einem ersten Zeitschritt verwendet. In den nachfolgenden Zeitschritten wird dann mehrfach nur der aus dem jeweiligen Schätzwert und dem Feinwinkelwert, vorzugsweise auch aus einem zusätzlichen Subwinkefwert, bestimmte Winkelwert verwendet.

Zur weiteren Verbesserung ist ein Subwinkelbereich vorgesehen, dessen Auflösung zwischen der Auflösung des Feinwinkelbereichs und des Teilwinkelbereichs vorgesehen ist.

**In einer ersten Ausführungsvariante** werden zwei Spuren vorgesehen, nämlich die Teilwinkelspur und die Feinwinkelspur. Dabei sind in Umfangsrichtung m Teilwinkelberieche angeordnet und die Teilwinkelbereiche in Umfangsrichtung gleich lang. Ebenso sind die Feinwinkelbereiche in Umfangsrichtung gleich lang. Jedem Teilwinkelabschnitt sind die gleiche Anzahl von Feinwinkelbereichen zugeordnet, wobei diese Anzahl jeweils von 0 bis n - 1 durchzählbar ist. Dabei ist m und n jeweils ganzzahlig.

Nach einem ersten Zeitabschnitt, in welchem der Teilwinkelwert, also die Nummer des Teilwinkels vom Winkelsensor erfasst wird, und der Feinwinkelwert F1, also die Nummer des Feinwinkels vom Winkelsensor erfasst wird, wird nach einem Zeitabstand $\Delta t$ der Feinwinkelwert F2 erfasst.

Zur Bestimmung des Winkelwertes, also der fehlenden Information über den neuen Teilwinkelwert, wird aus der Differenz des neuen zum vorherigen Feinwinkelwert F2 - F1 und aus dem Vergleich von F1 und F2 bestimmt, ob ein Überlauf in positiver oder negativer Umdrehungsrichtung stattgefunden hat oder nicht. Hierzu ist wichtig, dass die mögliche maximale Winkelgeschwindigkeit v_max nur derart klein ist, dass gilt

$$- \;(\tfrac{1}{2} * m - 1) \le v\_max * \Delta t \le (\tfrac{1}{2} * m ),$$

Somit ist bei Überlauf nur der Eintritt in einen nächstbenachbarten Teilwinkel, also Teilwinkelbereich, möglich. Wenn also die Winkelerfassung in sehr kleinem Zeitabstand $\Delta t$ ausgeführt wird, ist eine eindeutige Rekonstruktion des neu erfassten Winkelwertes aus der bloßen Information des neu erfassten Feinwinkelmesswertes und des vorigen Winkelwertes ermöglicht.

Diese Erfassung des Feinwinkelwertes ist nach einem jeweiligen weiteren Zeitabstand $\Delta t$ beliebig oft wiederhoibar. Somit genügt sogar die Übertragung des Feinwinkelwertes allein, um den jeweils neu erfassten Winkelwert zu bestimmen, wobei allerdings zu einem ersten Zeitpunkt der erfasste Winkelwert vollständig bekannt sein muss.

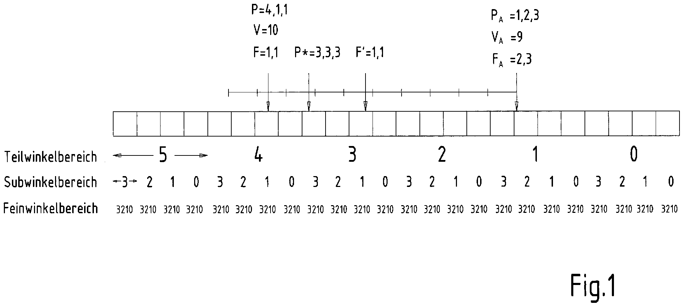

In der Figur 1 ist **eine zweite Ausführungsvariante mit drei** Spuren erläutert, nämlich mit einer Teilwinkelspur, einer Subwinkelspur und einer Feinwinkelspur, welche die Subwinkelspur feiner auflöst. Dabei sind in Umfangsrichtung m Teilwinkelberieche angeordnet, beispielsweise m = 32, und die Teilwinkelbereiche in Umfangsrichtung gleich lang. Ebenso sind die Subwinkelbereiche in Umfangsrichtung jeweils gleich lang, wobei jeder Teilwinkel in n Subwinkelbereiche aufgeteilt ist. Die Feinwinkelbereiche sind in Umfangsrichtung jeweils gleich lang, wobei jedem Subwinkelbereich q Feinwinkelbereiche zugeordnet sind. Jedem Teilwinkelabschnitt sind die gleiche Anzahl von Subwinkelbereichen zugeordnet, wobei diese Anzahl jeweils von 0 bis n -1 durchzählbar ist. Dabei ist m, q und n jeweils ganzzahlig. In Figur 1 ist q = 4 und n = 4.

Da die Winkelerfassung an einem System mit träger Masse ausgeführt wird und die auftretenden Beschleunigungen unterhalb eines Maximalwertes a_max liegen, ist eine Änderung der Winkelgeschwindigkeit innerhalb des Zeitabstandes $\Delta t$ nur um die maximale Geschwindigkeitsdifferenz

$$\Delta v\_max = \; a\_max * \Delta t$$

möglich.

Aus der zuletzt bekannten Winkelgeschwindigkeit v_alt und dem zuletzt bekannt Winkel a_alt ergibt sich ein Schätzwert

$$\alpha\_Sch\ddot{a}tz = \alpha\_alt + v\_alt \; * \Delta t$$

Die Winkeländerung zu diesem Schätzwert beträgt maximal Av_max * $\Delta t$ und erzeugt einen maximalen Überlauf des Subwinkels in den nächstbenachbarten Subwinkelbereich.

Daher muss zur Bestimmung des nächsten winkelwertes nicht der erfasste neue Wert des Teilwinkels, Subwinkels und Feinwinkels vorliegen sondern es genügen der Subwinkel und der Feinwinkel, wenn der für den vorigen Zeitabschnitt gültige Winkelwert bekannt ist. Denn aus dem Vergleich des alten Subwinkelwertes mit dem neuen Subwinkelwert und aus der Differenz zwischen neuem und alten Subwinkelwert ergibt sich der neue Subwinkelbereich. Da der neue Feinwinkel übermittelt ist, ist auch dieser Wert bekannt, wobei der Feinwinkelwert dem neuen Subwinkelwert eineindeutig einen Winkelwert zuordnet.

Dieses Verfahren ist in Figur 1 an einem **konkreten Beispiel darstellbar:** Der alte Winkelwert ist beispielhaft $P_A$ = (Teilwinkelwert = 1, Subwinkeiwert = 2 , Feinwinkelwert = 3). Dabei beträgt die alte Winkelgeschwindigkeit 9 Subwinkelbereiche pro Zeitabschnitt $\Delta t$.

Somit ergibt sich ein Schätzwert von P*= (Teilwinkelwert = 3, Subwinkelwert = 3, Feinwinkelwert = 3).

Wenn nun der neue Messwert den Feinwinkel 1 und Subwinkel 1 aufweist, ergeben sich zwei mögliche Winkelwerte, die als F = (Subwinkel 1, Feinwinkel 1) und F' = (Subwinkel 1, Feinwinkel 1) bezeichnet sind. Da nun aber die maximal auftretende Geschwindigkeitsänderung Av_max = a_max * Δt wiederum derart gewählt ist, dass Av_max * Δt kleiner als der halbe Teilwinkelbereich ist, wird durch die Differenzbildung und den Vergleich klar feststellbar, dass der neue Winkelwert F ist, aber nicht F'. Der neue Winkelwert wird somit bestimmt als P= (Teilwinkelwert = 4, Subwinkelwert = 1, Feinwinkelwert = 1), woraus die neue Geschwindigkeit als 10 Subwinkelbereiche pro Zeitabschnitt Δt bestimmt wird. Eine Übertragung des neu erfassten Teilwinkelwertes ist also einsparbar.

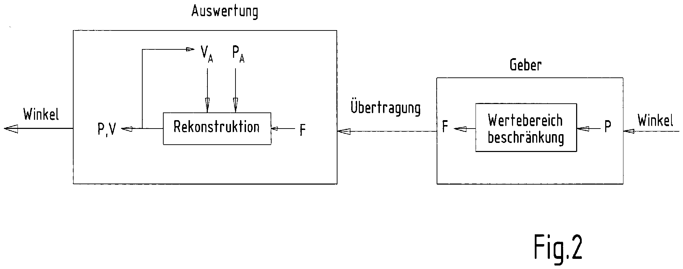

In Figur 2 ist das Verfahren näher dargestellt. Dabei wird zunächst die neu erfasste Information über den Winkelwert P im Winkelsensor reduziert auf eine Teilinformation F, welche nur den Subwinketwert und den Feinwinkelwert, nicht aber den Teilwinkelwert enthält. Dieser Wert F wird übertragen an die Auswerteschaltung, welche vorzugsweise in der Steuerelektronik eines Wechselrichters oder Umrichters angeordnet ist.

In der Auswerteschaltung wird aus der Teilinformation F unter Berücksichtigung des zuvor erfassten oder bestimmten Winkelwertes $P_A$ und der zuvor bestimmten Winkelgeschwindigkeit $v_A$ der neu erfasste Winkelwert P und die neu auftretende Winkelgeschwindigkeit v bestimmt.

**Bezugszeichenliste**

$P_A$ zuvor erfasster Winkelwert
P* Schätzwert für Winkel
P neu bestimmter Winkelwert
F Zwischenwert
F' zweiter Zwischenwert
$v_A$ zuvor bestimmte Winkelgeschwindigkeit

**Patentansprüche**

1.  Verfahren zur zyklischen digitalen Übertragung eines Positionswertes eines bewegten Objektes mit träger Masse, **wobei eine Auswerteeinheit verwendet wird,**
    **dadurch gekennzeichnet, dass**
    der Wertebereich des übertragenen Positionswertes derart eingeschränkt ist, dass sich keine vollständige Umdrehung oder im Fall einer linearen Bewegung andere durch mechanische Gegebenheiten bedingte vollständige Periode abbilden lässt und die tatsächliche Position durch Erkennen von Wertebereichsüberschreitungen in der Auswerteeinheit gebildet wird,

    - wobei zu einem ersten Zeitpunkt eine nicht **wertebereichsbeschränkte Position übertragen wird** oder eine **im Vergleich zum kontinuierlichen Betrieb** weit weniger stark wertebereichsbeschränkte Position übertragen wird
    - und/oder wobei der Wertebereich möglichst klein gewählt wird aber derart bestimmt wird, dass die in einem Abtastzyklus **bei maximaler Geschwindigkeit** auftretende Wegdifferenz kleiner als die Hälfte des Wertebereichs ist,

2.  Verfahren nach Anspruch 1,
    **dadurch gekennzeichnet, dass** der Positionswert einen Winkelwert $P_A$ eines drehenden Teiles, also Objektes, wobei das Objekt als träge Masse ein Trägheitsmoment aufweist.

3.  Verfahren nach mindestens einem der vorangegangenen Ansprüche,
    **dadurch gekennzeichnet, dass**
    die Übertragung zeitlich wiederkehrend wiederholt wird, insbesondere also zyklisch wiederholt wird, insbesondere in regelmäßigen Zeitabständen,

4.  Verfahren nach mindestens einem der vorangegangenen Ansprüche,
    **dadurch gekennzeichnet, dass**
    aus dem zuvor erfassten oder bestimmten Positionswert und der zugehörigen Geschwindigkeit ein Schätzwert bestimmt wird und der zweite Wert des neu erfassten Positionswertes mit dem zweiten Wert des Schätzwertes verglichen wird und die Differenz zwischen dem zweiten Wert des neu erfassten Positionswertes und dem zweiten Wert des Schätzwertes bestimmt wird und daraus der zum neu erfassten Positionswert zugehörige Positionsbereich bestimmt wird.

5.  Verfahren nach mindestens einem der vorangegangenen Ansprüche,
    **dadurch gekennzeichnet, dass**
    die Differenz zwischen neu erfasstem zweiten Wert und zuvor erfasstem zweiten Wert bestimmt wird, insbesondere wobei bei Überschreiten eines halben Positionsbereichs darauf geschlossen wird, dass der neu erfasste Positionswert in einem benachbarten Positionsbereich liegt.

6.  Verfahren nach mindestens einem der vorangegangenen Ansprüche,
    **dadurch gekennzeichnet, dass**
    ein Vergleich zwischen neu erfasstem zweiten Wert und zuvor erfasstem zweiten Wert bestimmt wird und bei derjenige benachbarte Bereich bestimmt wird, in welchem der neu erfasste Positionswert sich befindet, insbesondere wenn die Differenz zwischen neu erfasstem zweiten Wert und zuvor erfasstem zweiten Wert einen halben Positionsbereich überschreitet.

7.  Verfahren nach mindestens einem der vorangegangenen Ansprüche,

**dadurch gekennzeichnet, dass**

die Änderung der Geschwindigkeit zwischen zwei in einem Zeitabstand $\Delta t$ nacheinander ausgeführten Positionserfassungen auf einen kritischen Wert begrenzt ist, insbesondere welcher durch die träge Masse bestimmt oder zumindest mitbestimmt ist.

**8.** Verfahren nach mindestens einem der vorangegangenen Ansprüche,

**dadurch gekennzeichnet, dass**

der Positionswert $P_A$ ein Winkelwert oder eine Linearposition ist, insbesondere wobei die Geschwindigkeit eine Winkelgeschwindigkeit $v_A$ oder eine in Linearrichtung auftretende Geschwindigkeit ist.

**9.** Verfahren nach mindestens einem der vorangegangenen Ansprüche,

**dadurch gekennzeichnet, dass**

wobei erster und zweiter Wert einer jeweiligen Spur, insbesondere Geberspur, zugeordnet sind, wobei der erste Wert einer feiner auflösenden Spur als der zweite Wert zugeordnet ist.

**10.** Verfahren nach Ansprüche 4, 5, 6 oder 9,

**dadurch gekennzeichnet, dass**

**jeder Positionsbereich durch einen zweiten Wert, insbesondere Subwinketwert, gekennzeichnet ist, wobei**

jedem durch einen zweiten Wert, insbesondere Subwinkelwert, gekennzeichneten Positionsbereich zueinander separate Teilbereiche des Positionsbereichs zugeordnet sind, wobei jeder dieser Teilbereiche durch einen dritten Wert, insbesondere Feinwinkelwert, gekennzeichnet ist, der als ganze Zahl kennzeichenbar ist,

insbesondere wobei zu dem ersten Zeitpunkt der Positionswert erfasst wird und der zugehörige erste und zweite und dritte Wert übertragen wird,

wobei der dritte mit dem zweiten Wert übertragen wird, insbesondere vor oder nach dem zweiten Wert.

**11.** Vorrichtung, **mit einer Regelvorrichtung, die zur Regelung eines Antriebs ausgelegt ist,** wobei die Vorrichtung so ausgebildet ist ein Verfahren nach mindestens einem der vorangegangenen Ansprüche auszuführen,

wobei

in einem Sensor ein Positionswert erfasst wird und der Sensor über eine digitale Schnittstelle mit einer Auswerteeinheit verbunden ist,

wobei die Auswerteeinheit einen Speicher aufweist und Mittel aufweist, die dazu ausgelegt sind, den Positionswert aus einem übertragenen wertebereichsbeschränkten Positionswert aufweist,

wobei die Auswerteeinheit mit einer Regeleinrichtung verbunden ist.

**Claims**

**1.** A method for the cyclic digital transmission of a position value of a moving object having inertial mass, wherein an evaluation unit is used,

**characterised in that**

the range of values of the transmitted position value is restricted such that no complete revolution, or in the case of a linear movement other complete period contingent on mechanical conditions, can be mapped, and the actual position is formed by recognition of instances of exceedance of a range of values in the evaluation unit,

- with at a first point in time a not value-range-restricted position being transmitted or a far less greatly value-range-restricted position compared with continuous operation being transmitted

- and/or wherein the range of values is chosen to be as small as possible but is determined such that the path difference occurring in a scanning cycle at maximum speed is less than half the range of values.

**2.** A method according to Claim 1,

**characterised in that** the position value has an angle value $P_A$ of a rotating part, i.e. object, the object having a moment of inertia as inertial mass.

**3.** A method according to at least one of the preceding claims,

**characterised in that**

the transmission is periodically repeated, in particular therefore is repeated cyclically, in particular at regular intervals.

**4.** A method according to at least one of the preceding claims,

**characterised in that**

an estimated value is determined from the previously detected or determined position value and the associated speed, and the second value of the newly detected position value is compared with the second value of the estimated value, and the difference between the second value of the newly detected position value and the second value of the estimated value is determined and the position range associated with the newly detected position value is determined therefrom.

**5.** A method according to at least one of the preceding claims,

**characterised in that**

the difference between the newly detected second value and the previously detected second value is determined, in particular with a conclusion being drawn if a half position range is exceeded that the newly detected position value lies in an adjacent position range.

6. A method according to at least one of the preceding claims,
**characterised in that**
a comparison between the newly detected second value and the previously detected second value is determined, and [in] that adjacent range in which the newly detected position value is located is determined, in particular if the difference between the newly detected second value and the previously detected second value exceeds a half position range.

7. A method according to at least one of the preceding claims,
**characterised in that**
the change in the speed between two position detections carried out in succession in an interval $\Delta t$ is limited to a critical value, in particular which is determined or at least co-determined by the inertial mass.

8. A method according to at least one of the preceding claims,
**characterised in that**
the position value $P_A$ is an angle value or a linear position, in particular with the speed being an angular velocity $v_A$ or a speed occurring in a linear direction.

9. A method according to at least one of the preceding claims,
**characterised in that**
wherein [sic] the first and second values are associated with a respective track, in particular encoder track, the first value being associated with a track of finer resolution than the second value.

10. A method according to Claims 4, 5, 6 or 9,
**characterised in that**
each position range is **characterised by** a second value, in particular subangle value, wherein partial ranges of the position range which are separate from each other are associated with each position range which is **characterised by** a second value, in particular subangle value, each of these partial ranges being **characterised by** a third value, in particular fine angle value, which can be characterised as a whole number,
in particular with the position value being detected at the first point in time and the associated first and second and third values being transmitted,
the third value being transmitted with the second value, in particular before or after the second value.

11. A device, with a control device, which is designed to control a drive, wherein the device is formed so as to carry out a method according to at least one of the preceding claims,
wherein
in a sensor a position value is detected and the sensor is connected via a digital interface to an evaluation unit,
wherein the evaluation unit has a memory and has means which are designed to the position value has [sic] from a transmitted value-range-restricted position value,
wherein the evaluation unit is connected to a control means.

**Revendications**

1. Procédé de transmission numérique cyclique d'une valeur de position d'un objet en mouvement pourvu d'une masse inerte, dans lequel une unité d'évaluation est utilisée, **caractérisé en ce que**
la plage de valeurs de la valeur de position transmise est limitée de sorte qu'aucune révolution complète ou, dans le cas d'un mouvement linéaire, aucune autre période complète liée à des conditions mécaniques ne puisse être reproduite et la position réelle est formée par détection de dépassements de la plage de valeurs dans l'unité d'évaluation,

- dans lequel, à un premier instant, une position non limitée dans sa plage de valeurs est transmise ou une position beaucoup moins fortement limitée dans sa plage de valeurs par rapport au fonctionnement continu est transmise,
- et/ou dans lequel la plage de valeurs est choisie aussi petite que possible mais est déterminée de sorte que la différence de parcours apparaissant dans un cycle d'échantillonnage à la vitesse maximale soit inférieure à la moitié de la plage de valeurs,
- et/ou dans lequel la différence par rapport à la position précédente avec même limitation de la plage de valeurs est transmise à la place de la position absolue limitée dans sa plage de valeurs.

2. Procédé selon la revendication 1,
**caractérisé en ce**
**que** la valeur de position est une valeur d'angle $P_A$ d'une pièce, donc d'un objet, en rotation, l'objet présentant, en tant que masse inerte, un moment d'inertie.

3. Procédé selon au moins l'une des revendications précédentes,
**caractérisé en ce**
**que** la transmission est répétée de façon récurrente dans le temps, donc en particulier répétée cycliquement, en particulier à intervalles de temps réguliers.

4. Procédé selon au moins l'une des revendications précédentes,
**caractérisé en ce**

**qu'**une valeur estimée est déterminée à partir de la valeur de position précédemment détectée ou déterminée et de la vitesse associée et la deuxième valeur de la valeur de position nouvellement détectée est comparée avec la deuxième valeur de la valeur estimée et la différence entre la deuxième valeur de la valeur de position nouvellement détectée et la deuxième valeur de la valeur estimée est déterminée et utilisée pour déterminer la plage de positions associée à la valeur de position nouvellement détectée.

5. Procédé selon au moins l'une des revendications précédentes,
caractérisé en ce
la différence entre la deuxième valeur nouvellement détectée et la deuxième valeur précédemment détectée est déterminée, en particulier dans lequel, en cas de dépassement d'une demi-plage de positions, on conclut que la valeur de position nouvellement détectée se situe dans une plage de positions voisine.

6. Procédé selon au moins l'une des revendications précédentes,
**caractérisé en ce**

**qu'**une comparaison entre la deuxième valeur nouvellement détectée et la deuxième valeur précédemment détectée est déterminée et la plage voisine dans laquelle la valeur de position nouvellement détectée se trouve est déterminée, en particulier lorsque la différence entre la deuxième valeur nouvellement détectée et la deuxième valeur précédemment détectée dépasse une demi-plage de positions.

7. Procédé selon au moins l'une des revendications précédentes,
**caractérisé en ce**

**que** le changement de vitesse entre deux détections de position effectuées l'une après l'autre à un intervalle de temps $\Delta t$ est limité à une valeur critique, laquelle est en particulier déterminée ou au moins partiellement déterminée par la masse inerte.

8. Procédé selon au moins l'une des revendications précédentes,
**caractérisé en ce**

**que** la valeur de position $P_A$ est une valeur d'angle ou une position linéaire, la vitesse étant en particulier une vitesse angulaire $v_A$ ou une vitesse apparaissant en direction linéaire.

9. Procédé selon au moins l'une des revendications précédentes,
**caractérisé en ce**

**qu'**une première et deuxième valeur sont associées à une piste respective, en particulier une piste de codeur, la première valeur étant associée à une piste à résolution plus fine que la deuxième valeur.

10. Procédé selon les revendications 4, 5, 6 ou 9,
**caractérisé en ce**

**que** chaque plage de position est **caractérisée par** une deuxième valeur, en particulier une valeur de sous-angle, dans lequel

à chaque plage de positions **caractérisée par** une deuxième valeur, en particulier une valeur de sous-angle, sont associées des plages partielles séparées entre elles de la plage de positions, chacune de ces plages partielles étant **caractérisée par** une troisième valeur, en particulier une valeur d'angle fin, qui peut être **caractérisée** comme un nombre entier, en particulier dans lequel, au premier instant, la valeur de position est détectée et la première, la deuxième et la troisième valeur associée sont transmises,

la troisième valeur étant transmise avec la deuxième valeur, en particulier avant ou après la deuxième valeur.

11. Dispositif, comprenant un dispositif de régulation qui est conçu pour réguler une unité d'entraînement, lequel dispositif est conçu pour mettre en oeuvre un procédé selon au moins l'une des revendications précédentes,

dans lequel une valeur de position est détectée dans un capteur et le capteur est relié à une unité d'évaluation par l'intermédiaire d'une interface numérique,

dans lequel l'unité d'évaluation présente une mémoire et des moyens qui sont conçus pour déterminer la valeur de position à partir d'une valeur de position transmise, limitée dans sa plage de valeurs,

dans lequel l'unité d'évaluation est reliée à un dispositif de régulation.

P=4,1,1
V=10
F=1,1   P⋆=3,3,3   F'=1,1

$P_A$ =1,2,3
$V_A$ =9
$F_A$ =2,3

Teilwinkelbereich ← 5 → 4 3 2 1 0

Subwinkelbereich ←3→ 2 1 0 3 2 1 0 3 2 1 0 3 2 1 0 3 2 1 0 3 2 1 0

Feinwinkelbereich 3210 3210 3210 3210 3210 3210 3210 3210 3210 3210 3210 3210 3210 3210 3210 3210 3210 3210 3210 3210 3210 3210 3210 3210

Fig.1

Fig.2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102007062333 B3